Europäisches Patentamt

European Patent Office

Office européen des brevets

(19)

(11) Numéro de publication: 0 687 071 A1

## (12) DEMANDE DE BREVET EUROPEEN

(21) Numéro de dépôt: 95201432.2

(22) Date de dépôt: 01.06.95

(51) Int. Cl.⁶: H03K 19/0952, H03K 3/356

(30) Priorité: 08.06.94 FR 9407014

(43) Date de publication de la demande:
13.12.95 Bulletin 95/50

(84) Etats contractants désignés:
DE FR GB

(71) Demandeur: LABORATOIRES
D'ELECTRONIOUE PHILIPS
22, Avenue Descartes
F-94450 Limeil-Brévannes (FR)

(84) FR

(71) Demandeur: Philips Electronics N.V.
Groenewoudseweg 1
NL-5621 BA Eindhoven (NL)

(84) DE GB

(72) Inventeur: Caglio, Nathalie
Société Civile S.P.I.D.,
156, Boulevard Haussmann
F-75008 Paris (FR)
Inventeur: Meignant, Didier
Société Civile S.P.I.D.,
156, Boulevard Haussmann
F-75008 Paris (FR)
Inventeur: Rousseau, Patrick
Société Civile S.P.I.D.,
156, Boulevard Haussmann
F-75008 Paris (FR)

(74) Mandataire: Lottin, Claudine
Société Civile S.P.I.D.
156, Boulevard Haussmann
F-75008 Paris (FR)

(54) Dispositif incluant un circuit à étages logiques dynamiques

(57) Dispositif comprenant un circuit incluant une pluralité d'étages (I11, II21 : I12, I22) à transistors pour réaliser des fonctions logiques, contrôlés par un signal de synchronisation appliqué respectivement sur l'électrode de commande d'un transistor (T11, T21 ; T12, T22) monté en interrupteur, dit transistor de transmission, à l'entrée de chaque étage logique, ce signal de synchronisation étant porté par une ligne conductrice (300,400) dite ligne de distribution d'horloge, caractérisé en ce que les transistors sont des transistors à effet de champ à barrière Schottky et en ce que le signal de synchronisation (CK,$\overline{CK}$) porté par la ligne de distribution d'horloge (300, 400) est appliqué à l'électrode de contrôle des transistors de transmission (T11, T21 ; T12, T22) respectivement à travers un étage tampon (I13, I23 ; I14, I24) par transistor de transmission.

Application : Diviseurs de fréquences formés de FLIP-FLOPs

FIG. 6A

EP 0 687 071 A1

L'invention concerne un dispositif comprenant un circuit, ce circuit incluant une pluralité d'étages à transistors pour réaliser des fonctions logiques, contrôlés par un signal de synchronisation appliqué respectivement sur l'électrode de commande d'un transistor monté en interrupteur, dit transistor de transmission, à l'entrée de chaque étage logique, ce signal de synchronisation porté par une ligne conductrice dite ligne de distribution d'horloge.

L'invention trouve son application dans la réalisation de circuits intégrés incluant des étages synchronisés pour réaliser des fonctions logiques, dit étages logiques dynamiques, formés de transistors à effet de champ à barrière Schottky.

Par circuits à étages logiques dynamiques, on entend des circuits formés d'étages dont les niveaux logiques ne sont pas stables, et doivent donc être "rafraîchis" périodiquement. Pour réaliser cette opération, chaque étage dynamique est contrôlé par un signal d'horloge. Ce signal d'horloge est appliqué à cet effet sur l'électrode de commande d'un transistor à effet de champ monté en interrupteur dit transistor de transmission, en série avec l'entrée de l'étage dynamique. Ce signal d'horloge est généré par un sous-ensemble de circuit, appelé générateur d'horloge, qui, par un étage de sortie, fournit le signal d'horloge requis à une ligne de distribution qui transporte ce signal directement jusqu'aux électrodes de commande des transistors de transmission d'un nombre aussi grand que possible d'étages dynamiques, par exemple à 20 de ces étages dynamiques par étage de sortie du générateur d'horloge.

Il est déjà connu de l'état de la technique, par la demande de brevet japonais publiée sous le n° 264 813/92, (dont l'abrégé en anglais est disponible dans JAPANESE ABSTRACTS) un circuit comprenant deux étages inverseurs à transistors à effet de champ à barrière Schottky Q2, Q4, montés en série, et séparés l'un de l'autre par un transistor à effet de champ Q6 monté en interrupteur, dit transistor de transmission.

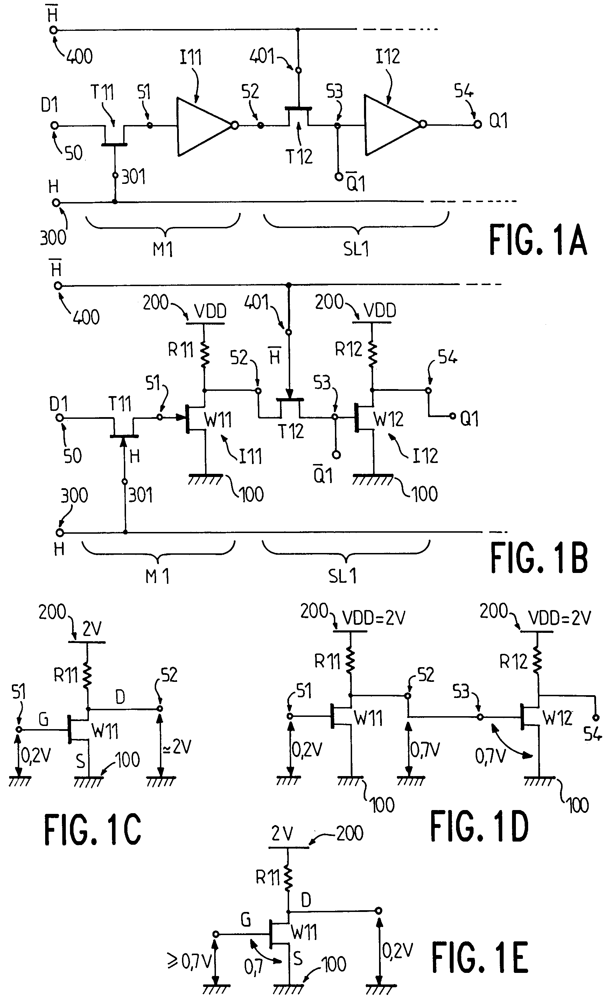

Le problème résolu par ce circuit connu concerne des moyens pour commander ce transistor monté en interrupteur Q6 lorsqu'il est choisi spécialement du type D-FET, c'est-à-dire à désertion de charges, normalement passant en l'absence de signal grille-source comme représenté sur la FIG.1 du document cité. Dans ce circuit connu, les transistors inverseurs Q2, Q4 des deux étages en série sont eux-mêmes du type à barrière Schottky à enrichissement, normalement bloqués en l'absence de signal grille-source, et sont polarisés, à travers une charge I1, I2 par une tension d'alimentation continue +2V.

Le problème est que, pour faire passer le transistor D-FET interrupteur Q6, de l'état normalement passant (N-ON) à l'état bloqué (OFF), il serait nécessaire d'appliquer sur sa grille un niveau négatif de tension si les sources des transistors inverseurs Q2, Q4 étaient reliées toutes deux directement à la masse.

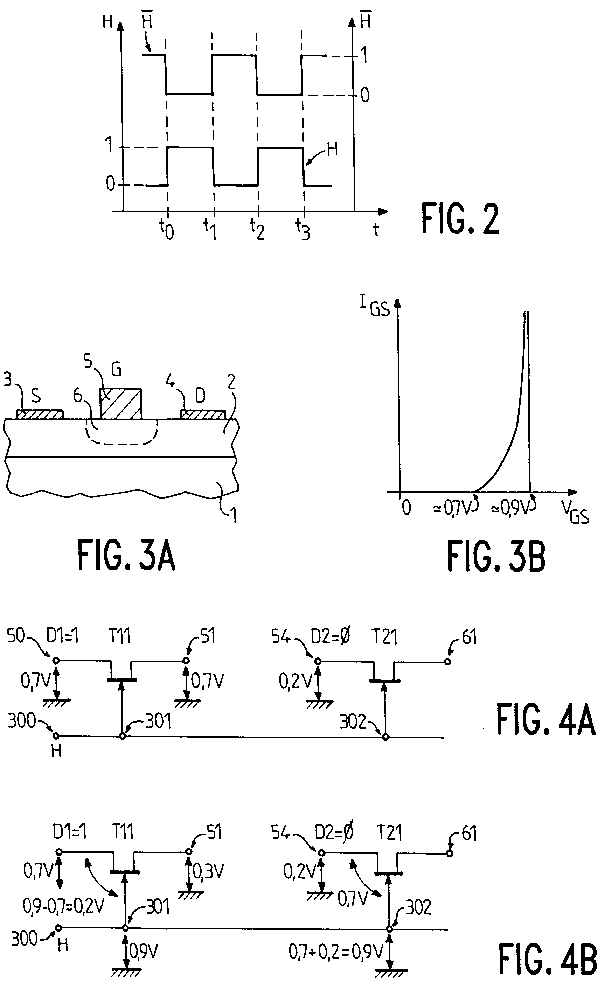

Le sous-circuit (B2) générateur d'horloge qui fournit le signal de commande de la tension de grille de ce transistor D-FET interrupteur Q6 ne peut fournir aisément une telle tension négative, car les niveaux des générateurs d'horloge sont généralement entre 1 et 0, concrétisés par des niveaux de tension toujours au moins légèrement positifs, comme il est connu de l'homme du métier. Cet inconvénient est évité en relevant les niveaux de tension des sources des deux transistors inverseurs Q2, Q4 au moyen d'éléments S1, S2 de décalage de niveau de tension. Ces éléments peuvent être des diodes (FIG.2A du document cité), ou des transistors montés en diodes (FIG.2B) ou des résistances (FIG.2C). Ces éléments sont montés entre source et masse des transistors inverseurs Q2, Q4.

Le résultat est que le transistor interrupteur D-FET Q6 (FIG.1) montre une tension grille-source comprise entre 1,1V et 0,6 V à l'état bloqué, lequel est alors obtenu en appliquant sur son noeud de grille b, au moyen du sous-circuit B2, une tension de commande de l'ordre de +0,1V. D'autre part, le transistor interrupteur D-FET Q6 montre une tension grille-source comprise entre -0,2 et +0,3V à l'état passant (ON), lequel est alors obtenu en appliquant sur son noeud de grille b, au moyen du sous-circuit B2, une tension de commande de l'ordre de +1V.

Ainsi le basculement du transistor D-FET Q6 peut être obtenu, alors que le sous-circuit B2 fournit une tension positive aussi bien pour obtenir l'état passant que pour obtenir l'état bloqué.

Le but de la présente invention est de traiter un tout autre problème qui se pose lors de la réalisation de circuit à étages logiques dynamiques formés de transistors à effet de champ à barrière Schottky.

Tout d'abord, l'homme du métier cherche à réaliser des circuits dynamiques parce que ces circuits permettent d'obtenir un meilleur compromis entre la vitesse de transfert et la consommation de puissance comparés aux circuits statiques.

Il est en effet déjà connu de l'homme du métier de réaliser des circuits logiques au moyen de transistors à effet de champ de divers types dits MOS (Metal-Oxyde-Semiconducteur) qui sont des transistors unipolaires généralement en silicium. Ces transistors présentent une forte ou assez forte capacité d'entrée de grille, puisque le métal de grille est appliqué sur le matériau semiconducteur par l'intermédiaire d'une couche d'oxyde. La diode inhérente au transistor formée entre grille et source ne devient donc jamais passante. Seule existe une tension de claquage qui est la tension grille-source pour laquelle la couche d'oxyde est détériorée.

Les circuits dynamiques formés d'étages à transistors MOS ne présentent donc aucun problème du type de celui traité par l'invention, mais dans le cas présent, le concepteur de circuits cherche à éviter d'utiliser ces transistors MOS pour des raisons de rapidité de commutation et de consommation de puissance.

Ayant fait ce choix préalable, l'homme du métier cherche à réaliser des circuits dynamiques ayant des étages logiques formés de transistors à effet de champ à barrière Schottky ou des transistors à effet de champ à jonction tels que les MESFETs (Metal-Semiconductor Field Effect Transistors) ou J-FETs (Junction Field Effect Transistors). Ces transistors unipolaires n'ont pas de couche d'oxyde entre le métal de grille et le matériau semiconducteur de la couche active et ils sont généralement en matériaux semiconducteurs du groupe III-V. Ils sont caractérisés par l'existence de deux diodes intrinsèques, l'une grille-source, l'autre grille-drain, dû à la symétrie de ces transistors, et n'ont pas une forte capacité d'entrée comme cela était le cas pour les transistors MOS. La courbe représentative du courant grille-source $I_{GS}$ en fonction de la tension grille-source $V_{GS}$, pour un étage inverseur classique (source à la masse, drain à une tension de polarisation à travers une charge), entrée sur la grille, sortie sur le drain) est une courbe exponentielle partant de 0 et ayant une asymptote verticale (parallèle à l'axe portant $I_{GS}$) correspondant à une tension $V_{GS}$ de l'ordre de moins d'un Volt. Cela signifie que dès que la tension grille-source $V_{GS}$ devient supérieure à une valeur donnée de l'ordre de 0,6 à 0,8 V, il apparait un courant grille-source $I_{GS}$, et que la diode grille-source devient donc conductrice. De plus, ce transistor se conduit comme un limiteur de tension puisque la tension grille-source $V_{GS}$ ne peut jamais dépasser la valeur de l'asymptote, c'est-à-dire 0,9V à 1V.

Cet effet de limitation de tension devient un inconvénient lorsque l'homme du métier se pose le problème de synchroniser différents étages logiques en appliquant un signal d'horloge sur chaque transistor de transmission montés en entrée de chacun des étages logiques dynamiques à synchroniser ; car selon l'état logique 0 ou 1 présent à l'entrée de l'étage logique, la commande de commutation du transistor de transmission par le signal d'horloge peut être complètement inefficace.

L'objet de l'invention est donc de fournir des moyens appliqués au circuit logique dynamique défini précédemment, pour que la commande d'une pluralité de transistors de transmission par un unique signal de synchronisation ou d'horloge soit toujours efficace.

Selon l'invention, ce problème est résolu par un circuit tel que décrit dans le préambule et en outre caractérisé en ce que les transistors sont des transistors à effet de champ à barrière Schottky et en ce que le signal de synchronisation porté par la ligne de distribution d'horloge est appliqué à l'électrode de contrôle des transistors de transmission respectivement à travers un étage tampon par transistor de transmission.

L'objet de l'invention est particulièrement avantageux dans la réalisation de bascules (FLIP-FLOPs) qui sont généralement des éléments de base des circuits logiques dynamiques tels que les diviseurs de fréquences pour convertisseurs de radio-fréquences notamment.

L'invention est décrite ci-après en détail en référence avec les figures schématiques ci-après annexées :

- la FIG.1A représente une bascule élémentaire maître-esclave en blocs fonctionnels ;
- la FIG.1B représente la même bascule élémentaire maître-esclave réalisée au moyen de transistors à effet de champ à barrière Schottky, à enrichissement ;
- la FIG. 1C représente un étage inverseur élémentaire formé d'un transistor à effet de champ à barrière Schottky à enrichissement recevant un signal zéro ;
- la FIG.1D représente deux de ces étages inverseurs élémentaires en série, le premier recevant un signal zéro ;
- la FIG.1E représente un étage tel que celui de la FIG.1C dans le cas où il reçoit un signal 1 ;
- la FIG.2 représente le chronogramme des signaux d'horloge H et de son complémentaire $\overline{H}$ ;
- la FIG.3A représente en coupe un transistor à effet de champ (MESFET) à barrière Schottky ;
- la FIG.3B représente la courbe du courant grille-source $I_{GS}$ en fonction de la tension grille-source $V_{GS}$ d'un étage inverseur élémentaire ;
- la FIG.4A illustre le fonctionnement espéré des transistors de transmission recevant le même signal de synchronisation distribué par la même ligne ;
- la FIG.4B illustre le fonctionnement qui est obtenu en réalité et qui diffère du fonctionnement espéré ;
- la FIG.5A montre un circuit formé de deux bascules maître-esclave montées directement en série, représenté en blocs fonctionnels ;
- la FIG.5B montre ce même circuit formé de transistors à effet de champ à barrière Schottky à enrichissement ;

- la FIG.6A montre le circuit formé de deux bascules maître-esclave de la FIG.5A, en outre muni des étages tampons appliqués entre les lignes de distribution d'horloge et les électrodes de commande des transistors de transmission, conformément à l'invention ;
- la FIG.6B montre le fonctionnement des étages tampons selon l'invention lorsqu'ils sont formés d'étages inverseurs à transistors à effet de champ à barrière Schottky à enrichissement.

L'invention est décrite ci-après à titre d'exemple non limitatif dans l'application à un dispositif incluant un circuit diviseur par 4 formé de deux bascules maître-esclave (FLIP-FLOP) montées en série, du type dit dynamique.

Ce circuit diviseur est choisi du type dynamique parce que cet agencement réduit sa consommation en puissance par 2 environ, par rapport à un circuit diviseur statique.

En référence avec la FIG.1A, une bascule maître-esclave de type dynamique comprend :
- une première cellule (LATCH) maître M1
- une seconde cellule (LATCH) esclave SL1 et ces deux cellules sont montées en série de sorte que la sortie 52 de l'étage maître M1 constitue l'entrée de l'étage esclave SL1.

Dans une mise en oeuvre avantageuse proposée par l'invention, chacune des cellules maître et esclave, respectivement M1 et SL2 est composée :
- d'un transistor, respectivement T11 dans le maître M1 et T12 dans l'esclave SL1, utilisé comme transistor de transmission (en anglais : TRANSFER GATE, SWITCH TRANSISTOR), formé d'un transistor à effet de champ à barrière Schottky (MESFET) ou à jonction (J-FET) monté en interrupteur, ayant sa source connectée au noeud d'entrée, 50 pour le maître, et 52 pour l'esclave, ayant son drain connecté au noeud 51 pour le maître et 53 pour l'esclave et ayant sa grille ou électrode de commande, connectée au noeud 301 pour le maître et 302 pour l'esclave. Les électrodes de commande des transistors interrupteurs T11 et T12 respectivement sont destinées à recevoir un signal de contrôle alternatif appelé signal d'horloge, H pour le maître, et son complémentaire $\overline{H}$ pour l'esclave : dans le cas étudié où cette bascule maître-esclave est l'un des éléments d'un diviseur de fréquence, la fréquence du signal d'horloge est la fréquence à diviser ;
- d'un inverseur, respectivement I11 dans le maître M1 et I12 dans l'esclave SL1 ; cet inverseur est favorablement du type appelé DCLF (en anglais Direct Coupled Fet Logic) ; dans ce cas cet inverseur se compose, comme montré sur la FIG.1B, d'un transistor, W11 dans le maître et W12 dans l'esclave respectivement, à effet de champ à barrière Schottky (MESFET) ou à jonction (J-FET), dont le drain, 52 pour le maître et 54 pour l'esclave est relié à une alimentation en continu $V_{DD}$ à travers une charge, R11 et R12 respectivement pour le maître M1 et l'esclave SL1, dont la source est reliée par exemple directement à la masse 100 (GROUND) et dont la grille ou électrode de commande est connectée au drain du transistor interrupteur de la cellule correspondante ; c'est-à-dire que dans le maître M1, la grille du transistor inverseur W11 est connectée, au noeud 51, au drain du transistor interrupteur T11 ; et dans l'esclave SL1, la grille du transistor inverseur W12 est connectée, au noeud 53, au drain du transistor interrupteur T12 ; la charge, respectivement R11 et R12, des transistors inverseurs W11 et W12 peut être une résistance, ou bien une charge active.

En référence avec la FIG.2 qui représente à titre d'exemple un signal d'horloge carré, ce signal d'horloge H montre, de l'instant to à l'instant t1, un état logique haut, c'est-à-dire un état logique 1 ; et de l'instant t1 l'instant t2, ce signal d'horloge H montre un état logique bas, c'est-à-dire un état logique ∅ (zéro).

Durant les périodes de temps où le signal d'horloge H qui commande le transistor interrupteur T11 du maître est à l'état haut, le signal d'horloge complémentaire $\overline{H}$ qui commande le transistor interrupteur T12 de l'esclave est à l'état bas (∅), et VICE VERSA.

L'utilisation de deux seules cellules maître-esclave comme montré sur les FIG.1A et 1B permet déjà de réaliser un diviseur de fréquence par deux. A cet effet, une donnée D1 est appliquée au noeud 50 constituant l'entrée du maître, c'est-à-dire sur la source du transistor interrupteur T11. Dès que le signal d'horloge H passe à l'état haut (1), le transistor interrupteur T11 devient passant et transmet la donnée au noeud 51, sur la grille du transistor inverseur W11 (voir la FIG.1A).

Si la donnée d'entrée D1, est un état logique 1, alors le transistor W11 devient passant, d'où il résulte qu'un état ∅ se retrouve sur son drain au noeud 52.

Si la donnée d'entrée D1 est au contraire un état logique ∅(zéro), le transistor inverseur W11 reste bloqué et l'état logique sur son drain 52 est un 1 ou état haut.

La fréquence du signal d'horloge H est prévue pour que le transfert de la donnée D1 du noeud 50 au noeud 52 se produise dans l'espace de temps de to à t1 pendant lequel le signal d'horloge H est à l'état haut, c'est-à-dire le transistor interrupteur T11 du maître passant ; et le transistor interrupteur T12 de l'esclave bloqué.

Ensuite, la fréquence du signal d'horloge H est telle que l'instant t1 à l'instant t2, ce signal d'horloge H est à l'état bas $\emptyset$(zéro), d'où il résulte que le transistor interrupteur T11 du maître est bloqué, et que le transistor interrupteur T12 de l'esclave est maintenant passant.

Dans ce cas, la donnée D1 inversée, appelée sortie $\overline{Q_1}$, arrivée au noeud 52, est transmise au noeud 53 sur la grille du transistor inverseur W12 de l'esclave ; et ensuite le transistor inverseur T12 permet l'apparition sur son drain 54 de la donnée à nouveau inversée appelée sortie Q1.

Il faut bien noter qu'il faut une période d'horloge complète de durée to → t2 pour que la donnée D1 placée au noeud d'entrée 50 du maître M1, parvienne au noeud 54 de sortie de l'esclave SL1.

Les niveaux logiques 1 ou $\emptyset$(zéro) qui correspondent aux données D1, Q1, $\overline{Q1}$ sont en réalité concrétisés par des niveaux de tension.

En référence avec les FIG.1C et 1E qui représentent le transistor inverseur W11, on montre les niveaux de tensions correspondant aux divers états logiques possibles.

Dans une première hypothèse illustrée par la FIG.1C, la donnée D1 appliquée sur la grille G du transistor inverseur W11, au noeud 51 est à l'état bas $\emptyset$(zéro). Comme on l'a dit plus haut, le transistor inverseur W11 est alors bloqué et aucun courant ne passe dans le canal. La tension sur le drain D de ce transistor est proche de la valeur de la tension d'alimentation en continu $V_{DD}$ = 2V, appliqué sur la ligne 200, compte tenu d'une faible chute de potentiel dans la charge R11. Par exemple, si la charge est une résistance, le potentiel sur le drain D au noeud 52, correspondant à l'état logique 1, sera $V_{DS} \simeq 2$ V.

En référence avec la FIG.1D il faut tenir compte du fait que cet état logique 1 doit être transmis au noeud 53 sur la grille du transistor inverseur W12 de l'esclave, dès que le transistor interrupteur T12 devient passant.

En référence avec la FIG.3A, on rappelle qu'un transistor à effet de champ du type MESFET, est essentiellement constitué d'un substrat semiconducteur 1, par exemple en un matériau semiconducteur du groupe III-V, d'une couche active 2, de deux contacts ohmiques 3, 4 jouant un rôle symétrique et d'un contact de grille de type Schottky directement en contact avec la couche active 2. En l'absence de signal grille-source, aucun courant ne passe normalement dans le canal formé par la couche active. Le transistor à effet de champ est bloqué. L'application d'un signal grille-source rend le transistor passant de telle manière qu'un courant s'instaure entre source et drain, l'épaisseur de la zone désertée 6 variant avec le signal appliqué sur la grille. Ce transistor est équivalent à deux diodes Schottky dont l'une est disposée entre grille et source et l'autre entre grille et drain.

Dès que le transistor T12 deivent passant dans la FIG.1D, on constate, en référence avec la FIG.3B qui représente le courant grille-source $V_{GS}$ d'un transistor MESFET tel que représenté sur la FIG.3A, ou J-FET du type à enrichement, utilisé selon l'invention, (normalement bloqué en l'absence de signal grille-source, et dans un inverseur élémentaire comme montré FIG.1C et FIG.1E), que, lorsque la tension grille-source $V_{GS}$ augmente, le courant grille-source $I_{GS}$ augmente exponentiellement. Il en résulte que la tension grille-source $V_{GS}$ tend vers une valeur asymptotique et ne peut de manière générale, dépasser une valeur de l'ordre de 0,7 V.

Donc l'état logique 1, qui aurait dû correspondre à environ 2 V entre drain et source du premier transistor inverseur W11 (FIG.1C), se voit AUTOMATIQUEMENT limité à la valeur de la tension grille-source maximale $V_{GS} \simeq 0,7$ V du transistor inverseur ultérieur W12, dès que le transistor interrupteur T12 disposé entre ces inverseurs W11, W12, devient passant, comme montré sur la FIG.1D.

Dans une seconde hypothèse, illustrée par la FIG.1E, la donnée D1 appliquée sur la grille du transistor inverseur W11, au noeud 51, est à l'état haut représenté par un 1. Comme on l'a dit plus haut, le transistor devient passant, sa tension de basculement étant de l'ordre de 0,35 V. L'état logique $\emptyset$ apparaît sur le drain D, en 52, de ce transistor inverseur W11, grâce au fait qu'un courant s'instaure dans le canal et la charge R11, entre la masse 100 et le noeud 200 d'application de la tension d'alimentation $V_{DD}$. Si la charge R11 est une résistance, compte tenu de la chute de potentiel à ses bornes, la tension drain-source $V_{DS}$ est alors proche du potentiel de masse, c'est-à-dire de l'ordre de $V_{DS} \simeq 0,2$ V.

Donc, dans un circuit tel que celui représenté sur les FIG.1A et 1B, les états logiques 1 et 0 correspondent à des niveaux de tension par rapport à la masse

état 1 ↔ niveau de tension ≃ 0,7 V
état 0 ↔ niveau de tension ≃ 0,2 V

En rebouclant le noeud 54 de la sortie de l'esclave SL1 sur l'entrée au noeud 50 du maître, par exemple au moyen d'un étage inverseur non représenté, dit étage de rebouclage, l'homme du métier peut obtenir aisément un circuit diviseur par deux de la fréquence de l'horloge H.

Le but de l'invention n'est pas de se limiter à un tel diviseur, mais au contraire de réaliser des circuits diviseurs de fréquence de toute sorte, diviseurs par 4, par 6, par 8, ainsi que par 5, 7 etc, tels que nécessités maintenant pour réaliser des dispositifs de réception audio ou vidéo.

Dès que le niveau de division de fréquence est supérieur à 2, il faut mettre en série, avec la première bascule maître-esclave décrite précédemment, au moins une seconde bascule maître-esclave.

Cette opération de mise en série de deux ou plusieurs bascules maître-esclave de type dynamique, réalisées au moyen de transistors à effet de champ MESFET ou J-FET en technologique DCFL n'est pas une opération de pure routine que l'homme du métier peut réaliser en répétant purement et simplement le seul circuit de bascule maître-esclave qui a été décrit précédemment.

Cette opération de mise en série pure et simple de deux ou plusieurs bascules maître-esclave telles que décrites précédemment, ne fonctionne pas, car les signaux de sortie deviennent incohérents, comme on va le montrer ci-après. L'homme du métier se trouve donc confronté à un problème.

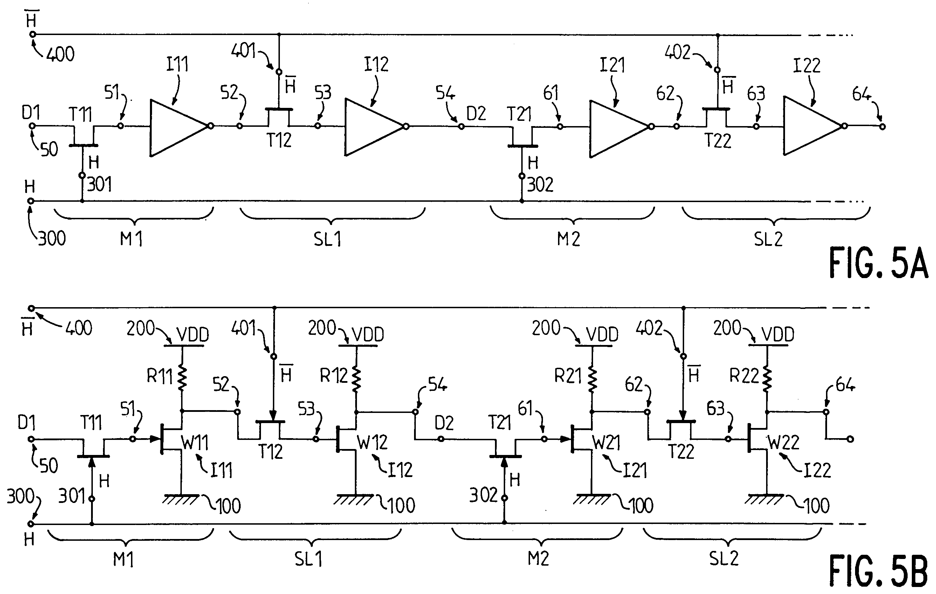

En référence avec la FIG.5A, on a représenté deux bascules maître-esclave du type de la FIG.1A purement mises en série.

La seconde bascule maître-esclave comporte les transistors interrupteurs T21, T22 ; et les étages inverseurs I21, I22. En référence avec la FIG.5B, ces étages inverseurs I21, I22 sont constitués des transistors inverseurs W21, W22, chargés respectivement par les charges R21, R22, avec leurs sources à la masse.

Les grilles 301 et 302 des transistors interrupteurs T11, T21 sont raccordés directement à la ligne de distribution 300 de signal d'horloge H afin d'assurer la synchronisation du fonctionnement de cellules maître M1 et M2, et les grilles 401 et 402 des transistors interrupteurs T12 et T22 sont raccordées directement à la ligne de distribution de signal d'horloge complémentaire $\overline{H}$ afin d'assurer la synchronisation du fonctionnement des cellules esclaves SL1 et SL2.

Dans ces conditions, le comportement attendu du circuit des FIG.5A et 5B est que durant une pleine période du signal d'horloge H représentée en référence avec la FIG.2 par un état haut suivi d'un état bas de ce signal d'horloge, c'est-à-dire durant (to, t1) + (t1, t2)

- la donnée D1 se propage de l'entrée 50 de la première bascule jusqu'à la sortie 54 de la première bascule, qui est aussi l'entrée de la seconde bascule, et arrive deux fois inversée à ce noeud 54,
- la donnée D2 se propage de l'entrée 54 de la deuxième bascule jusqu'à la sortie 64 de cette seconde bascule ;
- la propagation de ces données est simultanée puisque les deux cellules maîtres M1 et M2 sont synchronisées par le même signal d'horloge H, et que les deux cellules esclaves SL1 et SL2 sont synchronisées par le même signal d'horloge $\overline{H}$.

Le problème est qu'il n'en est pas ainsi comme on va le montrer ci-après.

En référence avec la FIG.4A, dans une hypothèse, on suppose que, à l'instant to, la donnée D1 appliquée à l'entrée au noeud 50 de la première cellule maître M1 est à l'état 1.

Dans cette même hypothèse, on suppose, ce qui est toujours possible, que la donnée D2 qui se trouve à cet instant de départ to sur le noeud 54 d'entrée de la seconde cellule maître M2 est à l'état ∅, c'est-à-dire que la différence de potentiel entre le noeud 54 et la masse 100 est :

$$V_{D2} \simeq 0.2 \text{ V.}$$

Dès que le premier transistor interrupteur T21 de la deuxième cellule maître M2 devient passant, la différence de potentiel entre sa grille en 302 et sa source en 54 est

$$V_{GS} \simeq 0.7 \text{ V}$$

En référence avec la FIG.4B, il en résulte que le potentiel entre cette grille en 302 et la masse 100 devient :

$V_H \simeq 0.7 + 0.2 \text{ V} = 0.9 \text{ V}$ qui impose le potentiel d'horloge H, quel que soit le potentiel imposé au départ sur la ligne de distribution d'horloge H pour réaliser le niveau haut (1) de ce signal d'horloge H.

Ce potentiel est évidemment le même que celui que l'on trouve sur la grille au noeud 301 du transistor interrupteur T11, puisque ce transistor est commandé par le même signal d'horloge H prélevé sur la même ligne de distribution 300 de sortie d'un unique circuit générateur d'horloge comme cela est habituellement connu de l'homme du métier des circuits intégrés.

Donc en 301, $V_H \simeq 0.9 \text{ V}$

On a pris pour hypothèse que la donnée D1 était à l'état haut (1), ce qui fait que le potentiel entre le noeud 50 et la masse est comme on l'a démontré plus haut, limité à une valeur de l'ordre de :

$$V_{D1} \simeq 0.7 \text{ V}$$

Mais du fait que le potentiel d'horloge $V_H$ entre le noeud 301 et la masse est 0,9 V, il en résulte, comme montré sur la FIG.4B, que le potentiel grille-source du premier transistor interrupteur T11 devient :

$$V_{GS} \simeq 0.9 - 0.7 = 0.2 \text{ V}$$

Dans ces conditions, ce premier transistor interrupteur T11, au lieu d'être pleinement passant, dans cette phase (to, t1) de commande de l'horloge H où l'état de cette dernière devrait être 1, est seulement légèrement passant : il en résulte qu'un signal de l'ordre de 0,3 V est trouvé entre la grille du premier transistor inverseur W11 et la masse, au lieu de 0,7 V qui était attendu au noeud 51, comme montré sur la FIG.4A.

De ce fait, la situation montrée sur la FIG.4A n'existe pas. Seule existe la situation montrée sur la FIG.4B.

Puisqu'on ne peut obtenir sur le drain du premier transistor interrupteur un niveau de tension égal à celui qui constituait la donnée D1 sur sa source, cela signifie que le niveau logique attendu est détérioré. Un tel événement peut se produire à tout endroit du circuit.

Il en résulte que tous les niveaux sont détériorés, et qu'aucun état franchement $\emptyset$ ou franchement 1 n'est capable de se propager dans ce circuit.

D'autre part, dans l'hypothèse inverse où la donnée D1 aurait été $\emptyset$ (zéro) en même temps que la donnée D2 était 1, alors le transistor de transmission T11 aurait imposé que le potentiel d'horloge soit $V_H = 0,9$, et il en aurait résulté le blocage partiel du transistor de transmission T21.

Bien entendu le problème des états de l'horloge $\overline{H}$ qui commande simultanément et directement les transistors interrupteurs T12 et T22 des cellules esclaves est exactement le même. D'où il résulte qu'il n'est pas possible de placer de telles bascules maîtres-esclaves dynamiques purement et simplement en série.

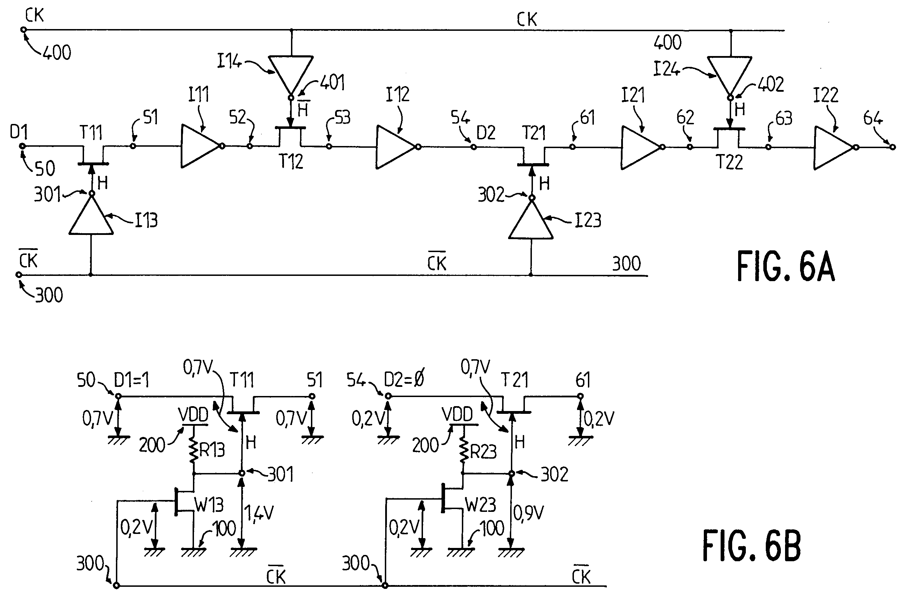

En référence avec la FIG.6A, selon l'invention ce problème est résolu en disposant des étages tampons, c'est-à-dire des étages tampons ou d'isolement des niveaux de tension I13, I14, I23, I24, entre chaque ligne 300, 400 de distribution du signal d'horloge dans le circuit et respectivement les grilles 301, 302 et 401, 402 de commande de tous les transistors interrupteurs d'un circuit tel que celui décrit en référence avec les FIG.5A et 5B.

Favorablement, un tel étage tampon ou d'isolement des niveaux de tension placé sur les grilles de commande de chaque transistor interrupteur, est formé par un étage inverseur I13, I14, I23, I24 et... respectivement du type des inverseurs I11, I12... etc, c'est-à-dire formé d'un transistor à effet de champ à enrichissement du type MESFET ou J-FET normalement bloqué en l'absence de signal grille-source, référencé W13, W23, W14, W24, etc..., dont le drain est relié à $V_{DD}$ par des charges, respectivement R13, R23, R14, R24, etc.

Du fait de la présence des étages inverseurs tampons I13, I14, I23, I24 etc, il faut désormais que le signal d'horloge, maintenant référencé $\overline{CK}$, qui est distribué sur la ligne 300, soit à l'état bas $\emptyset$ - (zéro) pour que, aux noeuds 301 et 302 sur les grilles des transistors interrupteurs T11 et T12, on dispose d'un signal d'horloge H à l'état haut fourni par les inverseurs tampons I13 et I23 qui reçoivent ce signal d'horloge $\overline{CK}$ en entrée.

De même pour les transistors interrupteurs T12 et T22 avec le signal d'horloge $\overline{H}$ fourni par les étages inverseurs tampons I14 et I24 à partir du signal d'horloge $\overline{CK}$ distribué par la ligne 400.

Maintenant, chaque étage inverseur I11, I12, I21, I22 des bascules maître-esclave fonctionne normalement comme il était attendu précédemment.

Par exemple, en référence avec la FIG.6B, si l'horloge $\overline{CK}$ est à l'état bas, le transistor inverseur W13 de l'étage tampon I13 est passant, et en transposant ce qu'on a dit plus haut en référence avec la FIG.4B, la différence de potentiel entre son drain, relié au noeud 301, et la masse 100, est,

$V_H \simeq V_{D1} + V_{GS} = 0,7 + 0,7 \simeq 1,4$ V (potentiel d'horloge H en 301)

Par contre, un potentiel :

$V_H \simeq V_{D2} + V_{G2} \simeq 0,9$ V (potentiel d'horloge H en 302) peut être trouvé au même instant, de la même façon, sur la grille en 302 du transistor interrupteur T21 de la deuxième cellule maître M2. Les niveaux de tension qui commandent les transistors de transmission T11, T21 sont maintenant isolés les uns des autres par chaque étage inverseur tampon I13, I23 appliqué entre la ligne de distribution d'horloge 300 et l'électrode de grille 301, 302 de ces transistors de transmission T11, T21.

Le potentiel sur la grille 301 du transistor interrupteur T11 n'est plus dans l'interdépendance du potentiel sur la grille 302 du transistor interrupteur T21, quel que soit l'état des données D1 et D2. Il n'y a plus de corrélation entre les potentiels sur les grilles 301, 302 des transistors interrupteurs synchronisés T11 et T21. De même pour T12 et T22 grâce aux étages tampons d'isolation I14 et I24.

En conséquence, maintenant, quel que soit le niveau de tension correspondant à l'état de la donnée D1, ou D2 à transmettre, par exemple 0,7 V pour D1, et 0,2 V pour D2, la tension grille-source du transistor de transmission T11, sur lequel on applique le signal d'horloge H à l'état 1, est toujours suffisante, par exemple $V_{GS} = 0,7$ V, pour rendre ce transistor de transmission T11 franchement passant, car elle est complètement indépendante de la tension au noeud 54 de T21. Donc les états des données transmises sont également toujours franchement $\emptyset$ ou franchement 1, car ils ne sont plus dégradés.

Le même phénomène se produit maintenant aussi dans la commande des transistors de transmission T12 et T22 par l'horloge $\overline{H}$ fournie par l'intermédiaire des étages inverseurs tampons I14, I24, à partir du signal d'horloge référencé CK circulant sur la ligne de distribution 400.

Bien que le circuit selon l'invention contienne un nombre légèrement plus élevé d'éléments que l'homme du métier n'avait prévu pour monter une pluralité de bascules maître-esclave en série de manière à constituer les diviseurs de fréquence, ce circuit est encore largement plus avantageux pour l'application envisagée, que ne le serait un circuit statique.

L'invention peut être appliquée à tout type de circuit dynamique dans lesquels des dégradations de niveaux de tension, et donc d'état logique, apparaissent du fait de la mise en commun des lignes de distribution de signaux d'horloge.

Il est important de disposer un étage tampon d'isolation de structure identique sur chacun des noeuds du circuit qui sont synchronisés, afin de maintenir cette synchronisation.

## Revendications

1. Dispositif comprenant un circuit, ce circuit incluant une pluralité d'étages à transistors pour réaliser des fonctions logiques, contrôlés par un signal de synchronisation appliqué respectivement sur l'électrode de commande d'un transistor monté en interrupteur, dit transistor de transmission, à l'entrée de chaque étage logique, ce signal de synchronisation étant porté par une ligne conductrice dite ligne de distribution d'horloge, caractérisé en ce que les transistors sont des transistors à effet de champ à barrière Schottky et en ce que le signal de synchronisation porté par la ligne de distribution d'horloge est appliqué à l'électrode de contrôle des transistors de transmission respectivement à travers un étage tampon par transistor de transmission.

2. Dispositif selon la revendication 1, caractérisé en ce que les étages tampons sont des étages inverseurs formés de transistors à effet de champ à barrière Schottky, qui reçoivent en entrée le signal de synchronisation porté par la ligne de distribution d'horloge, et qui fournissent en sortie le signal de synchronisation des transistors de transmission.

3. Dispositif selon la revendication 1, caractérisé en ce que les étages logiques à transistors forment au moins deux bascules maître-esclave montées en série.

4. Dispositif selon la revendication 3, caractérisé en ce que, dans chaque bascule maître-esclave, l'élément maître et l'élément esclave sont formés respectivement chacun d'un étage inverseur monté en série avec un transistor de transmission monté en interrupteur en entrée de cet étage inverseur.

5. Dispositif selon la revendication 4, caractérisé en ce que, tous les étages inverseurs des éléments maître sont synchronisés par un premier signal d'horloge (H), et tous les étages inverseurs des éléments esclaves sont synchronisés par un second signal d'horloge ($\overline{H}$) complémentaire du premier signal d'horloge, ces premier et second signaux d'horloge étant respectivement disponibles en sortie des étages tampons relatifs à chaque transistor de transmission.

6. Dispositif selon la revendication 5, caractérisé en ce que les étages tampons sont des étages inverseurs formés de transistors à effet de champ à barrière Schottky, qui reçoivent en entrée le signal de synchronisation porté par la ligne de distribution d'horloge, et qui fournissent en sortie le signal de synchronisation des transistors de transmission.

7. Dispositif selon la revendication 6, caractérisé en ce qu'une sortie d'étage d'une des bascules maître-esclave, parmi la deuxième bascule à la dernière bascule, est rebouclée sur l'entrée de la première bascule par un étage de rebouclage, pour former un circuit diviseur de la fréquence du signal de synchronisation.

FIG. 1A

FIG. 1B

FIG. 1C

FIG. 1D

FIG. 1E

EP 0 687 071 A1

FIG. 2

FIG. 3A

FIG. 3B

FIG. 4A

FIG. 4B

10

FIG.5A

FIG.5B

FIG. 6A

FIG. 6B

EP 0 687 071 A1

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int.Cl.6) |
|---|---|---|---|
| X | PATENT ABSTRACTS OF JAPAN vol. 14, no. 483 (E-993) 22 Octobre 1990 & JP-A-02 199 913 (OKI ELECTRIC IND CO LTD) 8 Août 1990 | 1 | H03K19/0952 H03K3/356 |
| A | * abrégé * | 2-5 | |
| A | EP-A-0 467 273 (SONY CORP.) * colonne 3, ligne 24 - colonne 5, ligne 11; figures 2,4 * | 1,3-5 | |
| A | EP-A-0 345 893 (L.E.P. ET AL.) * page 3, ligne 25 - page 4, ligne 33; figures 1A-2 * | 1 | |

|  | DOMAINES TECHNIQUES RECHERCHES (Int.Cl.6) |
|---|---|
| | H03K |

Le présent rapport a été établi pour toutes les revendications

| Lieu de la recherche | Date d'achèvement de la recherche | Examinateur |
|---|---|---|
| BERLIN | 7 Août 1995 | Taylor, P |

EPO FORM 1503 03.82 (P04C02)